(19) Europäisches Patentamt
European Patent Office
Office européen des brevets

(11) EP 2 091 065 A1

(12) EUROPEAN PATENT APPLICATION

(43) Date of publication:
19.08.2009 Bulletin 2009/34

(51) Int Cl.:
H01J 37/285 (2006.01)   H01J 37/28 (2006.01)
H01J 37/244 (2006.01)

(21) Application number: 08002916.8

(22) Date of filing: 18.02.2008

(84) Designated Contracting States:
AT BE BG CH CY CZ DE DK EE ES FI FR GB GR
HR HU IE IS IT LI LT LU LV MC MT NL NO PL PT
RO SE SI SK TR
Designated Extension States:
AL BA MK RS

(71) Applicant: ETH Zurich
8092 Zürich (CH)

(72) Inventors:
• Kirk, Taryl
  8600 Dübendorf (CH)
• Ramsperger, Urs
  8047 Zürich (CH)
• Pescia, Danilo
  8049 Zürich (CH)

(54) **Low-voltage field emission scanning electron microscope**

(57) A microscope and a method of microscopically analyzing the surface of a sample (3) are proposed, including at least the following steps: I. effecting a relative movement between an electron emitter tip (1) and the surface of the sample so as to scan it in two lateral dimensions, using an electron emitter tip (1) with an effective emission radius of equal or less than 2nm as determined by the Fowler-Nordheim relationship; II. during this relative movement causing electrons (6) emitted from the tip (1) to impinge against the surface and secondary and/or backscattered electrons (4) to be emanating therefrom, wherein a constant potential difference is applied between the sample (3) and the tip (1), wherein a piezoelectric device is used to keep the tip-sample separation distance constant using a constant voltage applied to the z-axis piezo such that the distance between the sample (3) and the tip (1) is in the range of 10-70 nm; III. during this relative movement collecting the secondary and/or backscattered electrons (4) by using a detector (5,7) and/or measuring the change in field emission current; IV. processing and/or displaying the output signal from the detector (5,7) and/or the measurement of the field emission current in relation to a scanning position of the tip (1) thereby producing at least one surface topographic image.

Fig. 1

**Description**

TECHNICAL FIELD

The present invention relates to a cost-efficient electron microscope capable of imaging the top-most layer(s) of surfaces with high spatial resolution as well as to a method of operating such a microscope.

BACKGROUND OF THE INVENTION

R.D. Young et al in 1972 were the first to employ a field emission (FE) current between a sharp metallic tip and a sample to resolve surface features, as small as 400nm. In the experiment proposed by Young, a tip is brought in close proximity to the sample surface until the desired current is achieved. The tip is then rastered along the surface at a fixed current, which is maintained by a feedback controller that adjusts the vertical z-piezo voltage accordingly. The applied voltage was much larger than the work function of the emitting material, which results in a current-voltage (I-V) relation consistent with Fowler-Nordheim field emission. This mono-energetic primary beam of electrons impinges on the surface at a well-defined area and undergoes elastic as well as inelastic collisions, penetrating the outer-most layer(s) of the surface (<1nm). The ejected secondary electrons from the excitations were collected and detected using an electron multiplier. The variations in the electron intensity from the electron multiplier signal, as a function of scanning position, represented the surface topography.

Although this experiment by Young et al is conceptually similar to a scanning tunneling microscope (STM), it however generates images similar to a scanning electron microscope (SEM) without the need of a remote electron gun. A large tip radius and tip-sample separation however inhibited the resolution capabilities of the instrument.

In US 4,954,711 a 3 nm lateral resolution on a polycrystalline gold surface could be already achieved by measuring the variations of the electron intensity from an electron multiplier, FE-excited using a single atom (111)-oriented Tungsten tip. The primary beam of electrons was extracted from the STM tip via an aperture placed in between the tip and the sample. Single crystal Tungsten wires are expensive and single atom tips require an additional apparatus. The inclusion of apertures and the constant current mode in the method limit spacing, and prevent the positioning of the tip closer to the sample.

P.N. First et al in 1991 performed similar measurements as described in US 4,954,711, however spin analyzers were employed instead of an electron multiplier. Topography, electron intensity, and magnetization in the sample were simultaneously measured with a lateral resolution of about 50nm. The tip was rastered using constant current (CC) mode at a nominal distance of 100nm to the sample dynamically adjusted by a correspondingly controlled z-piezo using the "topografmer mode". Voltages ranging from 32 - 45V were applied between the tip and sample. The resulting topographic and electron intensity image exhibited the converse contrast, i.e. protrusions in the topographic image appeared as depressions in the electron intensity image.

In US 6,855,926 electron energy loss spectroscopy (EELS) is performed using a single crystal (111)-oriented Tungsten STM tip as a primary beam emitter. Here an energy analyzer was used to determine chemical surface properties. The tip radius, as determined by SEM, was allegedly about 10-30nm and obtained a lateral resolution of approximately 40nm. Movement of the tip in the vertical direction was controlled by a feedback loop controlling the z-piezo maintaining a constant current (CC) between the tip and the sample to maintain a distance of less than 200nm. The backscattered electrons entered the four-grid retarding field analyzer through a grounded first grid. No direct relationship was drawn between the highest topographic area and the highest reflected electron count rate image.

SUMMARY OF THE INVENTION

It is an object of the present invention to provide a simple and low-cost electron microscope method refined to overcome the problems of the prior aforementioned art at high spatial resolutions capable of being integrated into pre-existing secondary electron analysis systems.

To this end a method of microscopically analyzing the surface of a sample is proposed including at least the following elements:

    I. effecting a relative movement between an electron emitter tip and the surface of the sample so as to scan it in two lateral dimensions, using an electron emitter tip with an effective emission radius of equal or less than 2.5nm, preferably of less than 2nm, as determined by the Fowler-Nordheim relationship;

    II. during this relative movement causing electrons (6) emitted from the tip (1) to impinge on the surface and secondary and/or backscattered electrons (4) to be emanating therefrom, wherein a constant potential difference is applied between the sample (3) and the tip (1), wherein a piezoelectric device is used to keep the tip-sample separation distance constant using a constant voltage applied to the z-axis piezo such that the distance between the sample (3) and the tip (1) is in the range of 10-70 nm;

III. during this relative movement collecting the secondary and/or backscattered electrons (4) by using a detector (5,7) and/or measuring the change in field emission current;

IV.processing and/or displaying the output signal from the detector (5,7) and/or the measurement of the field emission current in relation to a scanning position of the tip (1) thereby producing at least one surface topographic image.

According to an embodiment of the invention for higher sensitivity of the detection, the detector is located within 1-2 cm from the beam of electrons emitted from the tip. Preferably, the axis of the detector is oriented at an angle in the range of 0-30°, preferably in the range of 0-10° in respect of the surface plane. Most preferably the detector is aligned parallel to the surface of the sample.

A particularly preferred method generates/displays/processes two surface topographic images, one based on the output signal from the detector and one based on measurement of the field emission (FE) current. Preferably in a subsequent step V. the surface topographic image based on the output signal from the detector and the surface topographic image based on the measurement of the field emission current are used for the generation of a single final surface image by optionally weighted averaging of the respective data points. Alternately or additionally it is possible to use therein a difference analysis of the respective data points to derive additional surface information such as chemical surface information. This can be supplemented by measurement of the energy/state of polarization or other properties of the electrons arriving at the detector.

It should be noted generally that this concomitant operation, i.e. detection of backscattered and/or secondary electrons and at the same time field emission current detection is only possible due to the specific selection of a very small tip apex, the operation in constant z-piezo voltage mode i.e. constant height (CH, z-piezo kept at a fixed position) and the small distance between the sample's surface and the tip. While the state-of-the-art discloses methods with small tips with detection of backscattered and/or secondary electrons, these methods always work with constant current (CC) mode, i.e. in a mode in which the vertical position of the z-piezo is continuously controlled using a variable voltage. Variations in the FE-current in this mode of operation are from a principal point of view not possible. This in combination with the larger distances between the sample and the tip does not allow the combination of the two surface detection methods. The combination of the two detection methods however greatly enhances the achievable information content and resolution.

According to a further embodiment of the invention for the detection a high sensitivity single crystal scintillator, in combination with a photomultiplier tube (PMT), is used, preferably of the two phases of ($Y_3Al_5O_{12}$) Yttrium-aluminum-perovskite or Yttrium-aluminum-garnet, or channel electron multiplier type or combinations thereof. Preferably, the sample is cleaned or very freshly prepared and for example prepared by using at least one cycle of sputtering and/or annealing prior to imaging using the above method.

According to the invention it is possible to use a polycrystalline Tungsten tip, preferably prepared by an electrochemical etching preferably followed by an additional annealing in vacuum, such as for example described in more detail below.

Typically, the constant voltage applied between the sample and the tip is in the range of 30-60 V. Preferably, the constant voltage is applied to the z-axis piezo such that the distance between the sample and the tip is in the range of 30-50 nm.

The present invention furthermore relates to a microscope, preferably for use in a method as described above. Such a microscope is preferably comprising an electron emitter tip and means for effecting a relative lateral movement between the electron emitter tip and the surface of a sample so as to scan it in two dimensions, wherein the electron emitter tip has an effective emission radius of equal or less than 2.5 or 2nm as determined by the Fowler-Nordheim relationship, comprising first means for causing electrons emitted from the tip to impinge on the surface and secondary and/or backscattered electrons to be emanating therefrom, wherein a constant potential difference is applied between the sample and the tip, and wherein a piezoelectric device is provided to keep the tip-sample separation distance constant using a constant voltage applied to the z-axis piezo such that the distance between the sample and the tip is in the range of 10-70 nm, comprising a detector for collecting the secondary and/or backscattered electrons, and comprising second means for processing and/or displaying the output signal from the detector and/or the measurement of the field emission current in relation to a scanning position of the tip thereby producing at least one surface topographic image.

Further embodiments of the present invention are outlined in the dependent claims. To summarize, the above object can for example be achieved according to the present invention with a field emission scanning electron microscope (FESEM) comprising:

(i) a sharp polycrystalline Tungsten tip, prepared by an electrochemical etching followed by an additional annealing in vacuum, to act as a field emission current source; wherein the effective emission radius is 2.5nm or less, as determined by the Fowler-Nordheim relationship;

(ii) means for traversing the tip relative to the sample; wherein the sample is properly prepared with the standard cycles of sputtering and/or annealing prior to imaging;

(iii) a variable bias voltage source is applied to the sample;

(iv) a piezoelectric device to control the tip-sample separation distance so that a constant voltage can be applied to the z-axis piezo (also called constant height mode);

(v) a means of controlling the operation of the device;

(vi) an electron detector to collect all electrons emanating from the sample surface; wherein the electron detector axis is positioned essentially parallel to the surface of the sample within 2cm from the edge of the sample;

(vii) a means of displaying the output signal from the electron detector in relation to a scanning position of the tip thereby producing an electron intensity image;

(viii) a means of displaying the output signal from the field emission current in relation to a scanning position of the tip thereby producing a field emission current image.

When a positive bias (larger than the work function of both the tip and the sample) is applied to the sample, a primary beam of electrons are emitted from the tip, subsequently producing reflected and secondary electrons from the surface. The separation between the tip and the sample is maintained by a z-axis piezo-electric drive in such a way that a constant voltage is applied. The surface of the sample is concurrently scanned by the tip. Hence the reflected/secondary electron intensity and the FE current map of the samples are both displayed as a function of the surface position in three dimensions. The reflected/secondary electron image can be equivalently compared to an SEM image. Although the present invention details a prototype for topographic analysis of the sample surface, subsequent characterization of the electrons may also be employed after collection, such as spin polarization, Auger, electron energy loss, and/or inverse photoemission. Hence the present invention is the basis of such additional characterization of the surface emitted electrons, where the initial primary beam injection and extraction of the electrons emanating from the surface are performed in the aforementioned manner. The instrument provides a simple, low-cost means of achieving high resolution surface analysis of the top-most layer(s) of the surface of interest.

SHORT DESCRIPTION OF THE FIGURES

Referring to the drawings, which are for the purpose of illustrating the present preferred embodiments of the invention and not for the purpose of limiting the same,

FIG. 1    is a schematic illustration displaying the basic principles underlying the detection process;

FIG. 2    is a graph in which the effective tip radius according to the Fowler-Nordheim relationship is plotted for various polycrystalline Tungsten tips;

FIG. 3    is a block diagram illustrating schematically elements of an electron microscope according to the present invention; and

FIG. 4    a) and b): three-dimensional rendering of W (110) micrographs are shown, wherein in a) 240 nm x 145 nm field emission current signal and in b) resultant secondary electron intensity image, the primary beam energy was 33.2eV with an initial field emission current of 50nA, and the tip-sample separation was initially at 50nm, the image was scanned in constant height mode with a rough correction for nonlinearities on the piezo displacement.

DETAILED DESCRIPTION OF THE PREFERRED EMBODIMENTS

In conventional SEM the lateral resolution is limited by the electron beam diameter impinging on the specimen surface and interaction volume of the electron collisions. This limit is also critical for the subsequent analysis of the resultant electrons, e.g. spin polarization, EELS, and Auger electron spectroscopy (AES). The close proximity between the probe and surface of a STM operating in field emission mode provides a means of overcoming this limit.

In this specification, we present a simple FESEM capable of imaging conducting surfaces with high spatial resolution. The nomenclature is taken from R. Wiesendanger's description of a breed of microscopes that generate images via FE-excitations from an STM tip (R. Wiesendanger, Scanning Probe Microscopy and Spectroscopy, pp. 193-197, Cambridge University Press, 1994).

As this microscope is the core of all such devices, it also allows for further characterization of the secondary electrons using pre-existing systems. High spatial resolution was achieved by adhering to established theoretical models relating to the beam width of FE-emitted electrons from a sharp Tungsten tip. Geometrical arguments were used to optimize the beam diameter by incorporating the F-N relationship, which was shown to mainly depend on the emitter radius and tip-sample separation gap. Hence the focus of the proposed method/system is to improve the resolution by manipulating these two parameters.

Here, the first topographic images of terraces and atomic steps on single crystal substrates are reported, to our knowledge not yet attained with remote tip SEM, resulting from the electron intensity. The simultaneously recorded FE current, limited only by the incident beam girth, closely resembles the topography of the electron intensity. This indicates that the maximum resolution, in accordance with the tip-sample geometry, has been reached. The FESEM does not generate an image from the feedback signal but rather from the electrons emanating from the specimen surface contributing to various properties. Complimentary STM imaging, directly following FESEM measurements, is feasible and can easily be performed. We assert that additional analysis of the secondary electrons will also exhibit a comparable resolution.

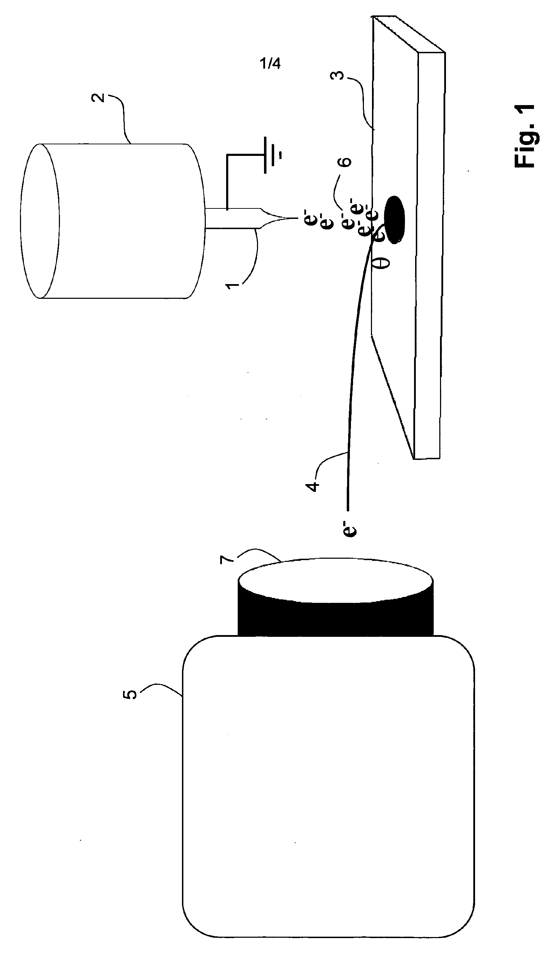

Referring now to Fig. 1 of the illustration, there is shown an STM tip 1 on an STM scanner head 2 to produce a primary beam of electrons 6. The tip 1 is formed by electro-chemical etching of a cylindrical polycrystalline tungsten wire in an electrolyte bath, e.g. NaOH or KOH as described by Lucier et al (Phys. Rev. B 72, 235420 (2005)). It is especially beneficial to adequately anneal the tip removing all residual Tungsten-oxides, which may cause primary beam instabilities. The tip can also be fabricated from single crystal Tungsten wires of (111), (310), or (100)-orientation, but these wires are delicate and costly. The terminating plane of polycrystalline Tungsten is normally (110), which has the highest work function, and can lead to a broad beam of field emitted electrons. However if the emission area is small enough and the tip is close enough to the surface the beam width will be significantly decreased, because the majority of the emitted electrons originate from the (111) plane.

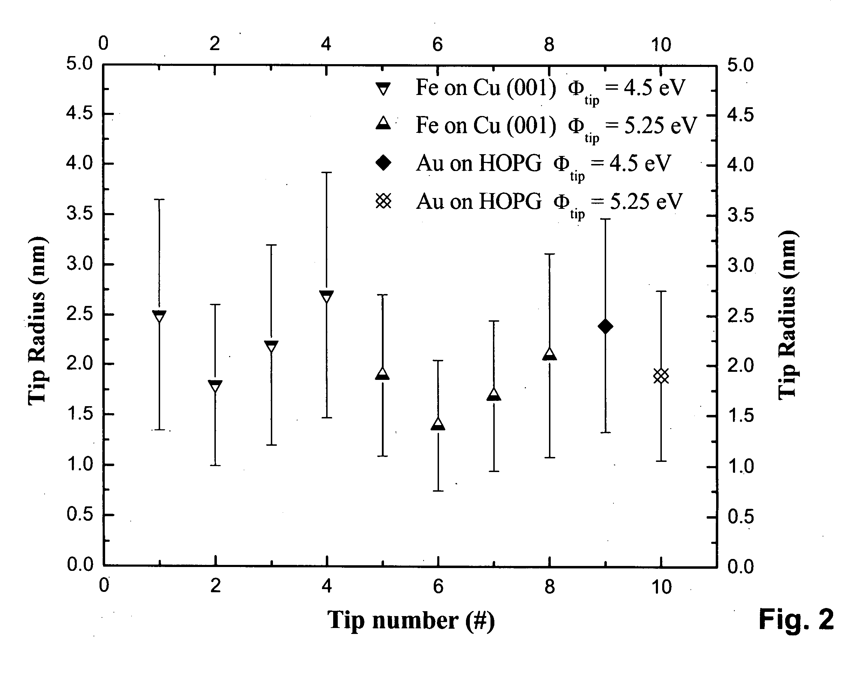

Therefore the tip should have an effective emission radius of a couple nanometers only and be placed as close as possible to the surface, preferably less than 50 nm. The effective emission radii are confirmed by reference to Fig. 2, which shows the radii for various polycrystalline Tungsten tips prior to imaging various surfaces.

The effective radii were calculated using the Fowler-Nordheim (F-N) relationship as described by R. Gomer (Havard Monographs in Applied Science Vol. 9, pp 47-49, Havard University Press, Cambridge, 1961). Neither field ion microscopy (FIM) nor SEM can be used to determine effective emission radii, because these methods do not provide any real-time information about the tip during operation. The sharpness of the tip is thus determined before it is mounted on the STM. A FE analysis on the tip is performed, which is similar but not identical to the one detailed in the above paper by Lucier et al (loc cit): The tip is brought in close proximity to a conducting sphere that is held at ground potential. A negative potential is then applied to the tip inducing a positive bias on the conducting sphere; hence FE electrons from the tip are collected via the conducting sphere. In general, the tip is held at a distance of about 5mm to the sphere and (-) 150V is applied to the tip yielding a FE current of 0.1nA. If the FE current value is not met, one slightly varies the distance between the tip and sphere. Next one increases the voltage until a FE current of 1.0nA is achieved, which is normally between (-) 160V - 165V. When these conditions are not met, the tip is rejected. Usually one can observe if a tip will meet these requirements with the aid of an optical microscope, but these I-V values ensure that the tip should exhibit an F-N relationship consistent with an effective emission radius of approximately 2nm.

The sample should be level with no large protrusion, i.e. much less than the tip-sample separation. The sample surface should also be cleaned preceding the imaging process. Well-known sputtering and annealing processes are sufficient; however a fresh surface without contaminants or oxides should be exposed for best results. Even in the best ultrahigh vacuum conditions (e.g. $2 \times 10^{-11}$ mbar), sample cleanliness can affect the amount of electrons ejected from the surface.

Fig. 1 shows the tip emitting a primary beam 6 of electrons that impinge on the sample surface 3 at currents on the order of tens of nano-amperes. Even though higher currents may increase the resolution of the image, it may also contaminate the surface and/or induce adsorbate motion between the tip and sample. The beam energy should be the minimum energy required to eject several electrons from the top-most layer of the surface, presumably less than 60eV.

Secondary and reflected electrons 4 will be deflected by the strong electric field between the tip 1 and sample 3, which directs the escaped electrons parallel to the surface. The electron detector 5,7, mounted essentially parallel to the sample surface, should cover an area large enough to encompass the entire sample. An acceleration voltage may be applied to the scintillator disk 7 or extraction optics; however it should not perturb the primary beam 6. Here the illustration shows a PMT 5 and scintillator 7 used for detecting the secondary electrons. The extraction voltage used is determined by the minimum acceleration voltage required to excite measurable photons at the scintillator disk 7 located at the entrance.

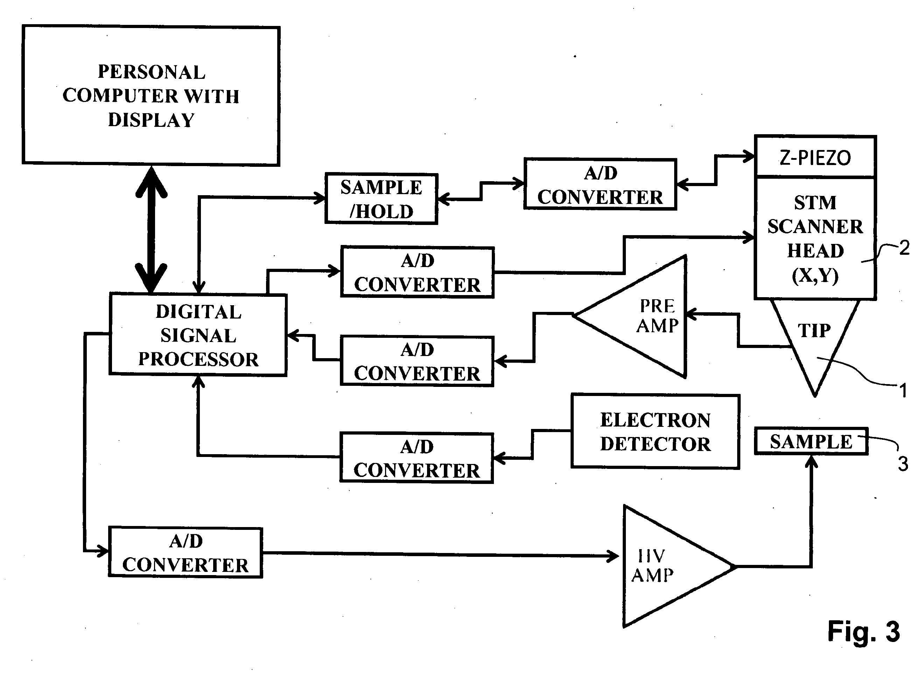

Referring to Fig. 3, there is shown a block diagram of the present invention. This microscope comprises an STM scanner head 2 having a conducting tip 1 attached to the front end. A variable bias voltage source applies a bias voltage, through a high voltage amplifier, between the tip 1 and the sample 3. A digital signal processor (DSP) regulates the tunnel current during approach by applying the required voltage to the z-piezo. The current is amplified $10^7$V/A (or less) before it is fed to the analog-to-digital converter (A/D). Switching the servo on or off maintains either a constant current between the tip and sample or a constant voltage to the z-piezo respectively. Preferred is constant voltage to the z-piezo (i.e. CH mode).

This is controlled via the DSP that receives commands from the scanning probe microscope (SPM) program of the personal computer (PC). The output signal from the electron detector, sent to the A/D converter, is synchronized with the current signal. The resulting images are simultaneously displayed on the PC.

When the tip is in close proximity to the sample, a coarse approach can be performed using typical STM values for the set current and applied bias, e.g. $I_T$ = 0.2nA and $V_T$ = 100mV. Such parameters place the tip within a nanometer of the sample surface, which can be used as a zero-point for the vertical positioning of the tip. The tip must be oriented so that it traverses parallel to the sample surface at a fixed tip height. Upon the retraction of the tip to the desired scan height, the voltage between the tip and sample may be increased until the desired field emission current is achieved. The I-V dependence should be consistent with the F-N relationship, e.g. 35V gives a current of 50nA for an effective emission radius of 2nm. If the radius is too large higher voltages will be needed to acquire the same currents as for smaller radii. Therefore broadening the beam width and deflecting more electrons back towards the surface. The smallest attainable effective emission radii exhibit the best results; nevertheless tip stability may be problematic in high field and currents. These parameters can be optimized via the tip-sample separation distance, which should essentially just be large enough to prevent contact with the surface.

The tip may be rastered along the sample surface with the servo switched off, i.e. CH mode, which is obtained using a sample-and-hold amplifier. Here this method is used to control small tip-sample spacing, since it is limited in CC mode by the high applied biases. CC mode is also more susceptible to large current jumps, thus quickly retracting the tip. Although the electron intensity does not depend strongly on tip-sample separation, many current jumps can distort the image. The tip can only be drawn to the surface in CH mode, enhancing the resolution. Optimally the topography from the electron intensity should match the topographic mapping of the field emission current, resulting in a lateral resolution limited only by the primary beam width, i.e. on the order sqrt((R+d)d)), where R is the emitter radius and d the distance between tip and sample (see Saenz et al., Appl. Phys. Lett. 65, 23,, 25 1994).

**Experimental section**

The experimental setup consists of a homemade modified Lyding-type STM installed in a small ultrahigh vacuum (UHV) chamber with a base pressure of $2\times10^{-11}$ mbar and a secondary electron detector (SED). UHV conditions are normally required to reduce surface contamination, which significantly reduces secondary electron yield, as well as increase the primary beam stability. The STM is suspended by four stainless steel springs for high frequency damping and additionally has eddy current damping magnets on the bottom-side of the base plate. The detectors can be mounted in close-proximity to the sample. Our SED is situated approximately 2cm from the sample edge and aligned to collect electrons ejected parallel to the surface see also Fig 1, in accordance with the deflection of electrons by the strong electric field between the tip and sample.

Secondary electrons are accelerated to an $Y_3Al_5O_{12}$ scintillator at energies up to 3KeV and converted to photons that travel along a 45cm Pyrex light guide to a Hamamatsu R268 photo-multiplier tube (PMT). A gold-coated Macor piece insulates the YAP scintillator and is at the same ground as the detector. Our SED, comprised of the scintillator and PMT, is mounted on a linear UHV manipulator with a travel distance of 10cm. In general, the primary beam energy is on the order of tens of eV; hence the backscattered electrons (BSE) have low energies. Angular resolved electron energy loss spectroscopic (EELS) measurements FE from an STM tip, where a distribution of BSE and SE were observed at angles θ ranging from -0.8° to 18° with respect to the sample surface plane. The majority of electrons were ejected parallel to the surface, but electrons of highest energy loss show trajectories bent towards the optical axis, in the direction of the primary beam. Both BSE and SE are sampled in the current setup, due to a large detector surface area and high electron acceleration voltages.

The samples and tips were prepared and characterized in situ via an adjacent interlocked UHV chamber (base pressure $1\times10^{-10}$ mbar) accommodated with low-energy electron diffraction /AES, sputter gun, mass spectrometer, molecular beam epitaxial capabilities, heating stage, and a sample/tip docking carousel. Sample cleaning is important for the secondary electron yield, even in optimal UHV conditions.

The tip was formed by electro-chemical etching of a cylindrical polycrystalline Tungsten wire in an electrolyte bath of NaOH. It is especially pertinent to adequately anneal the tip removing all residual $WO_3$ and $WO_2$, which may cause primary beam instabilities. The tip can also be fabricated from single crystal Tungsten wires of (111), (310), or (100) orientation. The terminating plane of polycrystalline Tungsten is normally (110), which has the highest work function (5.25 eV), can lead to a broad beam of FE electrons due to higher emission from neighboring planes. However if the emission area is small enough and the tip is close enough to the surface the beam width will be significantly decreased, because the majority of the emitted electrons originate from the (111) plane. Hence the effective work function is heavily weighted by the (111) plane resulting in a value of 4.5eV. Therefore the tip should have an effective emission radius of a couple nanometers and is placed as close as possible to the surface, usually less than 50nm.

Calculations using the F-N based FE analysis immediately preceding image scans, estimated the nominal emission radius. I-V values, recorded at the intended scan height, were inserted into the following enhanced F-N equation for the field emission current:

$$I(F) = 6.2 \times 10^{-6} A \frac{(\mu/\Phi)^{1/2}}{\alpha^2(\mu/\Phi)} F^2 \times \exp\left[-6.8 \times 10^7 \frac{\Phi^{3/2}\alpha}{F}\right] \tag{1}$$

where the current is given in Amperes, A is the emission area in $cm^2$, $\mu$ the chemical potential and the work function $\Phi$ in eV, $F$ the effective applied field in V/cm, and $\alpha$ is the image correction factor originating from the image charges on the surface. The image charge correction approaches unity for tips with a spherical apex on an orthogonal conical shank. Surface fields are reduced due to the tip apex geometry, as indicated in the following expression for the field at the exposed spherical region of the tip:

$$F = \frac{V}{k_f R} \tag{2}$$

with $V$ as the applied bias in Volts, $R$ the emission radius in cm, and $k_f$ is the field reduction factor. Consequently, the $k$-factor reduces the field as a result of the protrusion of the emitter from the shank. For example, the field is reduced less by the shank if the emitter is isolated on the orthogonal cone. Despite this uncertainty in the $k$-factor the effective emission radius can be calculated by inserting Eq. (2) into Eq. (1) and plotting $ln(I/V^2)$ versus $1/V$. Moreover a linear fit of slope $m$ results in a simple relationship containing the emission radius:

$$m = -6.8 x 10^7 \Phi^{3/2} \alpha k_f R \tag{3}$$

Figure 2 as discussed above shows the resultant effective emission radii for various samples, where each tip number represents a different Tungsten tip and the upper and lower limits refer to a k-factor of 3 and 8 respectively. Our findings indicate that the nominal effective emission radius is near 2nm. Note that increasing the tip work function decreases the emission radius for the same I-V values. Our Tungsten tip emission radii are reproducible and do not strongly depend on the conducting sample.

Upon measuring I-V curves, the tip was rastered along the sample surface with the servo switched off, i.e. constant height (CH) mode.

All of the presented samples were cleaned less than an hour before imaging, and the measurement chamber was shielded from external light to reduce the background on the PMT. Lower amplifications, $10^7$V/A instead of $10^8$V/A, of the FE current enabled us to measure higher current values. The bias voltages were modified through a stable high-voltage amplifier preceding the sample, in order to achieve the required voltages.

Typical primary beam energies range from 20eV-60eV, and though we measured signals on the PMT with FE currents as low as 0.2nA, high resolution images demanded currents between 20nA and 50nA.

Despite our instruments inability to effectively measure large structures, similar to the SEM, it can resolve nanometer-scale structures in three-dimensions. Now one substrate W (110) will be discussed.

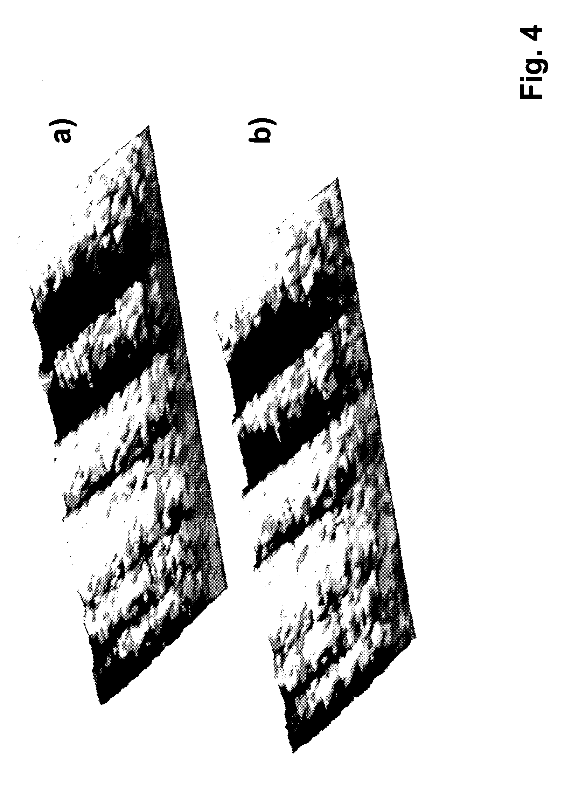

FESEM was performed on a single crystal W(110), where the omnipresent carbon lowers the work function (down to ~3.4eV) generating more BSE and SE at lower primary beam energies. An additional benefit was the robustness of tungsten, thus producing less adsorbate motion between the tip and sample. The electron intensity and corresponding FE current, Fig. 4 a and b, are indistinguishable, therefore contrary to backscattered electron imaging. Only rough corrections were made for nonlinearities in the piezo displacements, since it was difficult to find uniform structures in the STM images to calibrate the FESEM images. We took special care in centering the tip in order to traverse it parallel to the surface. The images were flattened to make all of the step features visible. Line scans, even without flattening the image, show sawtooth-like features where the terraces represent the increasing slop followed by a sharp drop-off at the step-edges. Edge enhancements are well-known in SEM imaging, and are caused by an increased production of secondary electrons (and backscattered electrons) near edges.

Subsequent imaging in normal STM CC mode show similar well-defined step features confirming the capability of the technique. Furthermore, the step edge width is almost identical to that measured with the STM. STM images show single atomic steps, with an average step height of 0.2nm, suggesting a FESEM vertical resolution of the same order. We have purposely flashed the W (110) substrate at ~2300°K in the absence of oxygen in order to bring carbon to the surface. The surface work function was lowered at the cost of contamination. After cycles of sputtering at 1KeV with currents of 150$\mu$A the contaminants remained, as is observed in both STM and FESEM images. Ultimately, the findings agree with a 1:1 linear relationship between beam diameter and tip-sample separation gap, in conjunction with J. Saenz's (see above) model, which predicts a lateral resolution of 3nm for a tip-sample separation of 3 - 5nm for an STM operating in field emission mode. These models were fully explored by approaching the surface, via the field effect; just avoiding a point contact and performing the usual scan. The tip was rastered from the bottom of the image (Fig. 4 a/b) upwards. Initially, the steps are not visible, but at as the tip drifts towards the surface, in the upper portion of the image, the terraces and atomic steps become more pronounced. We attribute this increase in resolution to a reduction of tip-sample separation which in turn reduces the beam diameter.

LIST OF REFERENCE NUMERALS

1    STM tip

2    STM scanner head

3    sample

4    secondary electron beam

5    photomultiplier

6    FE electron beam

7    scintillator

**Claims**

1.    A method of microscopically analyzing the surface of a sample (3)

   I. effecting a relative movement between an electron emitter tip (1) and the surface of the sample so as to scan it in two lateral dimensions, using an electron emitter tip (1) with an effective emission radius of equal or less than 2nm as determined by the Fowler-Nordheim relationship;
   II. during this relative movement causing electrons (6) emitted from the tip (1) to impinge on the surface and secondary and/or backscattered electrons (4) to be emanating therefrom, wherein a constant potential difference is applied between the sample (3) and the tip (1), wherein a piezoelectric device is used to keep the tip-sample separation distance constant using a constant voltage applied to the z-axis piezo such that the distance between the sample (3) and the tip (1) is in the range of 10-70 nm;
   III during this relative movement collecting the secondary and/or backscattered electrons (4) by using a detector (5,7) and/or measuring the change in field emission current;
   IV. processing and/or displaying the output signal from the detector (5,7) and/or the measurement of the field emission current in relation to a scanning position of the tip (1) thereby producing at least one surface topographic image.

2.    A method according to claim 1, wherein the detector (5,7) is located within 1-2 cm from the beam of electrons (6) emitted from the tip (1).

3.    A method according to one of the preceding claims, wherein the axis of the detector (5,7) is oriented at an angle in the range of 0-30°, preferably in the range of 0-10° in respect of the surface plane.

4. A method according to any of the preceding claims, wherein two surface topographic images are processed and/or displayed, one based on the output signal from the detector (5,7) and one based on measurement of the field emission current, and wherein in a subsequent step V. the surface topographic image based on the output signal from the detector (5,7) and the surface topographic image based on the measurement of the field emission current are used for the generation of a single final surface image by optionally weighted averaging of the respective data points, and/or are used in a difference analysis of the respective data points to derive additional surface information such as chemical surface information.

5. A method according to any of the preceding claims, wherein for the detection a high sensitivity detector preferably a scintillator is used, preferably of one of the two phases of $Y_3Al_5O_{12}$ type.

6. A method according to any of the preceding claims, wherein the sample is prepared by using at least one cycle of sputtering and/or annealing prior to imaging.

7. A method according to any of the preceding claims, wherein the tip is a polycrystalline tungsten tip, preferably prepared by an electrochemical etching preferably followed by an additional annealing in vacuum.

8. A method according to any of the preceding claims, wherein the constant potential applied between the sample (3) and the tip (1) is in the range of 30-60 V.

9. A method according to any of the preceding claims, wherein the constant voltage is applied to the z-axis piezo such that the distance between the sample (3) and the tip (1) is the in the range of 30-50 nm.

10. A microscope, preferably for use in a method according to any of the preceding claims, comprising an electron emitter tip (1) and means for effecting a relative lateral movement between the electron emitter tip (1) and the surface of a sample (3) so as to scan it in two dimensions, wherein the electron emitter tip (1) has an effective emission radius of equal or less than 2nm as determined by the Fowler-Nordheim relationship, comprising first means for causing electrons (6) emitted from the tip (1) to impinge on the surface and secondary and/or backscattered electrons (4) to be emanating therefrom, wherein a constant potential difference is applied between the sample (3) and the tip (1), and wherein a piezoelectric device is provided to keep the tip-sample separation distance constant using a constant voltage applied to the z-axis piezo such that the distance between the sample (3) and the tip (1) is in the range of 10-70 nm, comprising a detector (5,7) for collecting the secondary and/or backscattered electrons, and comprising second means for processing and/or displaying the output signal from the detector (5,7) and/or the measurement of the field emission current in relation to a scanning position of the tip (1) thereby producing at least one surface topographic image.

Fig. 1

Fig. 2

Fig. 3

Fig. 4

## DOCUMENTS CONSIDERED TO BE RELEVANT

**European Patent Office**   **EUROPEAN SEARCH REPORT**

Application Number

EP 08 00 2916

| Category | Citation of document with indication, where appropriate, of relevant passages | Relevant to claim | CLASSIFICATION OF THE APPLICATION (IPC) |
|---|---|---|---|
| X | FINK H-W: "POINT SOURCE FOR LONS AND ELECTRONS" PHYSICA SCRIPTA, STOCKHOLM, SE, vol. 38, no. 2, 1 August 1988 (1988-08-01), pages 260-263, XP000997813 * abstract; figures * section 2 on page 261 section 3 on pages 262-263 ----- | 1-3,6-10 | INV. H01J37/285 H01J37/28 H01J37/244 |
| X | US 4 665 313 A (WELLS OLIVER C [US]) 12 May 1987 (1987-05-12) * abstract; figures * * column 2, lines 41-68 * * column 4, lines 4-60 * * column 5, lines 5-50 * * column 6, lines 29-50 * ----- | 1,8,10 | |
| A | TOMITORI M ET AL: "ENERGY SPECTRUM OF BACKSCATTERED ELECTRONS EXCITED BY A FIELD EMISSION SCANNING TUNNELING MICROSCOPE WITH A BUILD-UP  not 111 3/4 -ORIENTED W TIP" APPLIED SURFACE SCIENCE, ELSEVIER, AMSTERDAM, NL, vol. 144, 1 January 1999 (1999-01-01), pages 123-127, XP000989436 ISSN: 0169-4332 * abstract; figure 1a * * page 124, left-hand column, last paragraph * * page 124, right-hand column, paragraph 2 - page 125, left-hand column, last paragraph * ----- | 3 | TECHNICAL FIELDS SEARCHED (IPC) H01J |

-/--

The present search report has been drawn up for all claims

| Place of search | Date of completion of the search | Examiner |
|---|---|---|
| Munich | 16 July 2008 | Opitz-Coutureau, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

**European Patent Office**

## EUROPEAN SEARCH REPORT

Application Number

EP 08 00 2916

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | ALLENSPACH R ET AL: "SPIN-POLARIZED SECONSARY FROM A SCANNING TUNNELING MICROSCOPE IN FIELD EMISSION MODE" APPLIED PHYSICS LETTERS, AIP, AMERICAN INSTITUTE OF PHYSICS, MELVILLE, NY, vol. 54, no. 6, 6 February 1989 (1989-02-06), pages 587-589, XP000027430 ISSN: 0003-6951 * abstract; figure 1 * * page 589, left-hand column, paragraph 2 * ----- | 8,9 | |
| A | EP 1 134 771 A (HITACHI EUROP LTD [GB]) 19 September 2001 (2001-09-19) * abstract; figures * * paragraphs [0017], [0029] - [0032] * * claims 2,3 * ----- | 1,10 | |
| A | US 2007/046172 A1 (SANDHU GURTEJ S [US] ET AL) 1 March 2007 (2007-03-01) * the whole document * ----- | 1-10 | TECHNICAL FIELDS SEARCHED (IPC) |

The present search report has been drawn up for all claims

| Place of search | Date of completion of the search | Examiner |
|---|---|---|
| Munich | 16 July 2008 | Opitz-Coutureau, J |

EPO FORM 1503 03.82 (P04C01)

## ANNEX TO THE EUROPEAN SEARCH REPORT
## ON EUROPEAN PATENT APPLICATION NO.

EP 08 00 2916

This annex lists the patent family members relating to the patent documents cited in the above-mentioned European search report.
The members are as contained in the European Patent Office EDP file on
The European Patent Office is in no way liable for these particulars which are merely given for the purpose of information.

16-07-2008

| Patent document cited in search report | | Publication date | Patent family member(s) | | Publication date |
|---|---|---|---|---|---|
| US 4665313 | A | 12-05-1987 | CA | 1236595 A1 | 10-05-1988 |
| | | | DE | 3674076 D1 | 18-10-1990 |
| | | | EP | 0206016 A2 | 30-12-1986 |
| | | | JP | 1651003 C | 30-03-1992 |
| | | | JP | 3012772 B | 21-02-1991 |
| | | | JP | 62004335 A | 10-01-1987 |
| EP 1134771 | A | 19-09-2001 | US | 2001040215 A1 | 15-11-2001 |
| US 2007046172 | A1 | 01-03-2007 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4954711 A

- US 6855926 B

**Non-patent literature cited in the description**

- **R. Wiesendanger.** Scanning Probe Microscopy and Spectroscopy. Cambridge University Press, 193-197
- **Lucier et al.** *Phys. Rev. B,* 2005, vol. 72, 235420

- **R. Gomer.** Havard Monographs in Applied Science. Havard University Press, 1961, vol. 9, 47-49
- **Saenz et al.** *Appl. Phys. Lett.,* 1994, vol. 65, 23, 25